# FASCICULE DE BREVET EUROPEEN

(11) **EP 2 899 295 B1**
(45) Date de publication et mention de la délivrance du brevet: **14.09.2016**
(21) Numéro de dépôt: 15152387.5
(22) Date de dépôt: 23.01.2015
(51) Int. Cl.: C23C 16/44, C23C 16/46, C23C 16/56, C23C 16/30, C23C 16/455

(54) **Procédé de réalisation par ALD d'une couche mince de formule MYx**
Verfahren zur Herstellung einer Dünnschicht einer MYx-Formel durch Atomlagenabscheidung
Method for producing a thin layer of formula MYx by ALD

(30) Priorité: 24.01.2014 FR 1450598
(43) Date de publication de la demande: 29.07.2015
(73) Titulaire: COMMISSARIAT A L'ENERGIE ATOMIQUE ET AUX ENERGIES ALTERNATIVES, 75015 Paris (FR); Centre National de la Recherche Scientifique, 75016 Paris (FR); UNIVERSITE CLAUDE BERNARD - LYON 1, 69100 Villeurbanne (FR); CPE Lyon Formation Continue et Recherche, 69100 Villeurbanne (FR)
(72) Inventeur: CADOT, Stéphane, 69730 GENAY (FR); MARTIN, François, 38000 GRENOBLE (FR); QUADRELLI, Elsje, 69003 LYON (FR); THIEULEUX, Chloé, 69100 VILLEURBANNE (FR)
(74) Mandataire: Cabinet Laurent & Charras

(56) Documents cités:
- US-A1- 2006 286 810
- SCHARF T W ET AL: "Growth, structure, and tribological behavior of atomic layer-deposited tungsten disulphide solid lubricant coatings with applications to MEMS", ACTA MATERIALIA, ELSEVIER, OXFORD, GB, vol. 54, no. 18, 1 octobre 2006 (2006-10-01), pages 4731-4743, XP027889496, ISSN: 1359-6454 [extrait le 2006-10-01]
- DATABASE COMPENDEX [Online] ENGINEERING INFORMATION, INC., NEW YORK, NY, US; 2005, SCHARF T W ET AL: "Atomic layer deposition of solid lubricant thin films", XP002727379, Database accession no. E2006099721470 & PROCEEDINGS OF THE WORLD TRIBOLOGY CONGRESS III - 2005 - PROCEEDINGS OF THE WORLD TRIBOLOGY CONGRESS III - 2005 2005 AMERICAN SOCIETY OF MECHANICAL ENGINEERS US, 2005, pages 375-376,

## Description

### DOMAINE DE L'INVENTION

L'invention concerne un procédé de réalisation d'un matériau couche mince de type MYₓ, M étant le tungstène et/ou le molybdène, et Y le soufre et/ou le sélénium.

Le domaine d'utilisation de la présente invention concerne notamment l'électronique.

### ETAT ANTERIEUR DE LA TECHNIQUE

L'utilisation de matériaux de type MYₓ (M = Mo, W ; Y = S, Se) dans la catalyse ou dans le domaine des revêtements lubrifiants a entrainé le développement de diverses techniques de fabrication, et plus particulièrement :
- la sulfuration des oxydes métalliques MoO₃ et WO₃ par H₂S ou par un mélange H₂/H₂S ;
- la décomposition thermique de thiomolybdates ou de thiotungstates ;
- la pulvérisation cathodique réactive ;
- la décomposition (thermique et/ou tribologique) de dithiocarbamates, thiophosphates ou thioxanthates de molybdène ou de tungstène ;
- le dépôt en phase vapeur (CVD - « *Chemical Vapor Deposition* ») par réaction entre un précurseur du métal tel que MoF₆, MoCl₅ ou Mo(CO)₆, et un précurseur soufré tel que l'hydrogène sulfuré ou le soufre élémentaire ;
- le dépôt en phase vapeur (CVD) à précurseur unique, par décomposition thermique de dithiocarbamates ou d'un tétrathiolate de molybdène (IV) ;
- le dépôt d'un matériau de type MY₂ (WS₂) par couche atomique (ALD) à partir de précurseurs volatiles halogénés du métal (WF₆).

Cependant, ces procédés conduisent généralement à :
- des dépôts poreux ; ou
- des dépôts contenant systématiquement des impuretés, particulièrement O, C, Cl et F, étant donné que les seuls exemples d'ALD directe de MoS₂ ou WS₂ décrits à ce jour mettent en oeuvre des chlorures ou des fluorures de Mo et W ; ou
- la formation de sous-produits corrosifs tels que HF et HCl pouvant détériorer le substrat.

En outre, ils ne permettent pas un contrôle précis de l'épaisseur et de l'homogénéité du dépôt formant la couche mince.

D'autre part, la couche mince obtenue selon ces procédés présente des plans cristallins n'étant pas tous orientés dans la même direction par rapport au substrat sur lequel le dépôt a été réalisé. En d'autres termes, ces procédés ne permettent pas, en général, un contrôle de l'orientation des plans cristallins dans la couche déposée. Bien que cette caractéristique ne soit pas un inconvénient dans le domaine de la catalyse par exemple, elle peut s'avérer problématique pour une utilisation en électronique notamment.

D'autres exemples de procédés de l'art antérieur permettant de former des couches minces de type MoS₂, incluent :
- la sulfuration d'un dépôt préformé de MoO₂ par le soufre élémentaire à 1000°C ;
- le dépôt par CVD de l'oxyde MoO₃ et du soufre élémentaire à 650 °C ;
- le transport physique de MoS₂ en phase vapeur à 900 °C ;
- le dépôt par CVD de MoCl₅ + H₂S à 600 °C. Ce procédé permet de former une couche de 50 nanomètres de MoS₂ orienté. Cependant, il ne permet pas un recouvrement optimal du substrat dès les premiers nanomètres déposés ;
- la pulvérisation cathodique qui peut également permettre la formation d'un dépôt orienté. Cependant, cette méthode ne permet pas de contrôler très précisément l'épaisseur, notamment en raison du manque d'homogénéité du dépôt. En effet, cette technique permet de contrôler l'épaisseur du dépôt à quelques dizaines de nanomètres près.

Quoi qu'il en soit, ces techniques présentent l'inconvénient de nécessiter généralement des températures très élevées, souvent supérieures à 650 °C, qui s'avèrent incompatibles avec les procédés de fabrication des circuits intégrés. En outre, elles ne permettent généralement pas la formation contrôlée de couches hybrides, c'est-à-dire une couche contenant un mélange de différents éléments M et/ou de différents éléments Y qui ont été déposés successivement.

Une alternative consiste à réaliser l'exfoliation de couches de MY₂ à l'aide d'un adhésif. Cependant, cette technique est limitée en termes de reproductibilité et d'applicabilité à grande échelle. D'autre part, elle ne permet pas la formation de couches minces hybrides à l'échelle industrielle. Elle nécessite également un matériau très pur et très cristallin.

Afin de remédier à ces problèmes, le Demandeur a mis au point un procédé permettant de préparer, dans des conditions douces (température de dépôt inférieure à 350 °C, absence d'impuretés halogénées), une couche mince de type MYₓ, par des dépôts successifs et autolimités d'un précurseur contenant M et d'un autre précurseur contenant Y. Ainsi, ce procédé permet non seulement de contrôler l'épaisseur de la couche mince plus précisément que les méthodes de l'art mais aussi la formation de couches hybrides.

### EXPOSE DE L'INVENTION

La présente invention concerne un procédé de préparation d'un matériau MYₓ se présentant sous forme d'une couche mince pouvant être amorphe, partiellement cristalline, ou totalement cristalline.

Par « couche mince », on entend une couche de matériau dont l'épaisseur est avantageusement comprise entre 0.5 et 100 nanomètres, plus avantageusement inférieure à 10 nanomètres, et encore plus avantageusement inférieure à 5 nanomètres.

Dans des conditions relativement clémentes, en termes de température de mise en oeuvre, le procédé - objet de l'invention permet de contrôler l'épaisseur et la stoechiométrie de la couche mince de MYₓ.

En outre, le procédé selon la présente invention permet également de former une couche mince hybride MYₓ dans laquelle M est du molybdène et/ou du tungstène et Y est du soufre et/ou du sélénium.

Plus précisément, l'objet de la présente invention concerne un procédé de préparation par ALD d'une couche mince de formule MYₓ, x étant compris entre 1.5 et 3.1. Ce procédé comprend l'étape de dépôt par ALD (de l'anglais « *Atomic Layer Deposition »* c'est-à-dire dépôt par couche atomique) de MYₓ sur un substrat à partir d'au moins un précurseur du métal M, et d'au moins un précurseur de l'élément Y ;
- M étant le tungstène et/ou le molybdène (en d'autres termes, M est choisi dans le groupe constitué du tungstène, du molybdène, et du mélange tungstène/molybdène) ;
- le degré d'oxydation du métal M dans le précurseur du métal M étant compris entre 3 et 6, de préférence égal à 3, 4, ou 6, et encore plus avantageusement égal à 4 ou 6 ;
- le métal du précurseur du métal M comprenant uniquement des liaisons M-Z et/ou M-M avec Z = C, N, H et toute combinaison de ces atomes ;
- Y étant le soufre et/ou le sélénium (en d'autres termes, Y est choisi dans le groupe constitué du soufre, du sélénium, et du mélange soufre/sélénium) ;
- la température du substrat étant inférieure ou égale à 350 °C.

Les liaisons M-Z et M-M mentionnées ci-dessus sont des liaisons pouvant être simples ou multiples.

De manière avantageuse, dans la formule MYₓ, x est compris entre 1.8 et 3.1, plus avantageusement entre 1.9 et 3, et encore plus avantageusement entre 2 et 3. Selon un mode de réalisation particulièrement avantageux, x = 2.

Typiquement, les techniques utilisées pour analyser la composition de la couche mince de formule MYₓ incluent les techniques suivantes :
- spectrométrie de photoélectrons induits par rayons-X : XPS (de l'acronyme anglais « *X-Ray photoelectron spectrometry* ») ;
- spectroscopie Raman ;
- spectrométrie de fluorescence X: XRF (de l'acronyme anglais «*X-Ray fluorescence* ») ;
- microscopie électronique haute résolution en transmission : HRTEM (de l'acronyme anglais « *High-resolution transmission electron microscopy* ») ;
- analyse élémentaire ;
- analyse dispersive en énergie : EDS ou EDX (de l'acronyme anglais « *energy dispersive X*-*ray spectrometry* ») ;
- spectrométrie de masse à ionisation secondaire : SIMS (de l'acronyme anglais « *Secondary Ion Mass Spectrometry* »).

De manière générale, et particulièrement pour la SIMS, l'appareil de mesure peut être préalablement calibré sur un échantillon de référence selon un mode opératoire classique faisant partie des connaissances générales de l'homme du métier.

### Modes de réalisation particuliers du procédé selon l'invention

Le dépôt par ALD de la couche mince MYₓ est réalisé dans une enceinte dans laquelle les précurseurs du métal M et de l'élément Y sont introduits séparément. Conformément à la mise en oeuvre de la technique d'ALD, les précurseurs sont introduits dans une chambre de dépôt, de manière alternée, et sous forme gazeuse, afin de contrôler la formation de la couche mince. En effet, l'introduction simultanée des précurseurs pourrait engendrer une réaction entre ces derniers avant d'atteindre le substrat sur lequel la couche mince est formée.

Les précurseurs sont généralement introduits sous forme gazeuse. Ils sont entraînés vers la zone de dépôt par un gaz inerte (argon ou azote par exemple). Toutefois, et selon un mode de réalisation particulier, ils peuvent être introduits sous forme diluée dans un solvant peu réactif et suffisamment volatile (toluène, benzène, hexane par exemple). Cette solution diluée de précurseur est alors nébulisée dans le flux du gaz porteur sous forme de spray.

Chaque précurseur est introduit par « pulse ». Chaque pulse correspond à l'entrainement vers le substrat d'un des précurseurs, par un flux de gaz pendant un laps de temps nécessaire à l'obtention d'un recouvrement optimum du substrat. L'homme du métier saura ajuster les paramètres nécessaires selon les méthodes conventionnelles de dépôt par ALD. La durée de pulse peut notamment dépendre de la nature de l'instrument utilisé. Ainsi et à titre d'exemple non limitatif, il peut être de l'ordre de quelques millisecondes à plusieurs minutes, par exemple de 100 millisecondes à 10 minutes.

Selon un mode de réalisation particulier, le dépôt par ALD comprend l'introduction dans une chambre de dépôt d'au moins un précurseur du métal M, et ensuite l'introduction d'au moins un précurseur de l'élément Y.

Selon un autre mode de réalisation particulier, le dépôt par ALD comprend l'introduction dans une chambre de dépôt d'au moins un précurseur de l'élément Y, et ensuite l'introduction d'au moins un précurseur du métal M.

Le dépôt par ALD peut ainsi comprendre les étapes suivantes :
a) introduire un premier précurseur du métal M ou de l'élément Y dans une chambre de dépôt ;
b) optionnellement, purger la chambre de dépôt avec un gaz inerte (argon ou azote par exemple) afin d'éliminer les espèces n'ayant pas réagi ;
c) introduire un deuxième précurseur dans la chambre de dépôt, le deuxième précurseur étant un précurseur du métal M lorsque le premier précurseur est un précurseur de l'élément Y ou un précurseur de l'élément Y lorsque le premier précurseur est un précurseur du métal M ;
d) optionnellement, purger la chambre de dépôt avec un gaz inerte (argon ou azote par exemple) afin d'éliminer les espèces n'ayant pas réagi ;
e) réitération des étapes a) à d).

De manière générale, l'introduction du premier précurseur est précédée d'une étape de purge de la chambre de dépôt. Le gaz inerte de purge est généralement de l'argon ou de l'azote. Il peut s'agir de tout gaz ne réagissant pas avec les précurseurs.

Les étapes a) à d) sont généralement réitérées jusqu'à l'obtention d'une couche mince ayant l'épaisseur souhaitée. Les précurseurs mis en oeuvre dans les étapes dites de réitération peuvent être identiques aux précurseurs initialement utilisés ou distincts. Par exemple, des précurseurs de molybdène de nature différente peuvent être utilisés pour former une couche mince MoYₓ. Des précurseurs de métaux différents peuvent également être utilisés pour former une couche mince hybride MYₓ avec M = Mo + W. Il en va de même pour le ou les précurseurs de Y.

Ainsi, et de manière générale, le dépôt par ALD peut comprendre d'une part l'introduction de précurseurs des métaux tungstène et/ou molybdène, et d'autre part l'introduction de précurseurs des éléments soufre et/ou sélénium. Ce mode de réalisation particulier permet de former une couche mince hybride MYₓ, dans laquelle M = (Mo et/ou W) et Y = (S et/ou Se).

Lors de l'introduction du premier précurseur, la surface du substrat est avantageusement saturée en métal M ou en élément Y, de manière à former un dépôt homogène qui recouvre avantageusement l'intégralité du substrat. Chaque introduction ultérieure de précurseur de M ou de Y permet de saturer la surface de la couche préalablement déposée.

Comme déjà dit, l'introduction des précurseurs du métal M et de l'élément Y est réalisée de manière alternée. L'ordre d'introduction peut notamment dépendre de la nature du substrat.

Par exemple et selon un mode de réalisation particulier, notamment lorsque le substrat est de type oxyde de métal ou oxyde organique, le procédé peut comprendre la séquence de pulses suivante :
- précurseur du métal M,
- précurseur de l'élément Y,
- précurseur du métal M,
- précurseur de l'élément Y.

Selon un autre mode de réalisation particulier, notamment lorsque le substrat est en métal (nickel, cuivre ou or par exemple), le procédé peut comprendre la séquence de pulses suivante :
- précurseur de l'élément Y,
- précurseur du métal M,
- précurseur de l'élément Y,
- précurseur du métal M,
- précurseur de l'élément Y.

L'homme du métier saura adapter la fréquence et la répétition des pulses en fonction du taux de recouvrement du substrat souhaité.

Le dépôt par ALD consiste notamment à porter les précurseurs à la température nécessaire pour obtenir une tension de vapeur suffisante à la pression de travail. Le précurseur est ensuite entrainé vers le substrat par un flux gazeux qui peut être inerte ou réactif. Les connaissances générales de l'homme du métier lui permettront d'ajuster la quantité de précurseur à injecter à chaque pulse, et la mise en oeuvre du dépôt par ALD.

Dans le cadre de la présente invention, le dépôt par ALD de la couche mince MYₓ est réalisé à une température inférieure ou égale à 350 °C. En d'autres termes, et comme déjà indiqué, la température du substrat est inférieure ou égale à 350 °C. Elle est plus avantageusement comprise entre 0 et 350 °C, et encore plus avantageusement entre 120 et 300 °C. Selon un autre mode de réalisation particulièrement avantageux, la température est comprise entre 20 et 350°C, avantageusement entre 20 et 300°C.

La température de dépôt peut être adaptée en fonction de la nature du couple de précurseurs mis en oeuvre. L'homme du métier saura adapter la température en fonction de la nature du couple de précurseurs mis en oeuvre.

Cependant, le dépôt par ALD est avantageusement réalisé à la même température pour tous les pulses de précurseurs mis en oeuvre.

Il peut également être réalisé sous pression réduite.

De manière générale, le procédé - objet de l'invention, est applicable à une production à grande échelle, et permet d'obtenir une couche mince MYₓ tout en assurant les effets techniques suivants :
- contrôle précis de l'épaisseur du dépôt ;
- possibilité de préparer des couches minces hybrides ;
- absence d'impuretés liées aux éléments O, F, Cl, Br, et I ;
- dépôt réalisé à basse température (≤ 350 °C) ;
- absence de rejets de composés dihalogènes ou d'halogénures d'hydrogène qui provoqueraient non seulement une corrosion du réacteur mais aussi du dépôt et du substrat.

### Précurseurs

De manière générale, les précurseurs du métal M et de l'élément Y sont avantageusement thermiquement stables à la température de dépôt par ALD. D'autre part, ils présentent une tension de vapeur convenable à la pression de travail et une réactivité permettant leur mise en oeuvre par ALD, à une température inférieure ou égale à 350 °C.

Les précurseurs du métal M sont des composés comprenant des ligands, c'est-à-dire des groupements directement liés au métal M. Lors de la formation de la couche mince MYₓ, ces ligands sont avantageusement intégralement substitués par les éléments Y. les ligands non substitués par les éléments Y sont généralement éliminés lors de l'étape ultérieure et optionnelle de recuit décrite ci-après.

Comme déjà indiqué, le précurseur du métal M est un composé du tungstène ou du molybdène comprenant des liaisons M-Z et/ou M-M avec Z = C, N, H et toute combinaison de ces atomes. Il peut s'agir de liaisons covalentes simples, doubles ou triples. De manière avantageuse, il comprend uniquement des liaisons M-Z. Cependant, et selon un mode de réalisation particulier, le métal du précurseur du métal M comprend exclusivement des liaisons simples et/ou doubles avec l'azote.

En outre, le précurseur du métal M est dépourvu d'halogènes. Il est également préférentiellement dépourvu d'oxygène.

Il s'agit avantageusement de composés mono-métalliques ou bi-métalliques. De manière préférée, il s'agit d'un composé mono-métallique ayant un degré d'oxydation égal à 4 ou 6.

De manière avantageuse, le précurseur du métal M est choisi dans le groupe comprenant les composés Mo(NMe₂)₄ ; M(=N-CMe₃)₂(NMe₂)₂ ; Mo(NEtMe)₄ ; Mo(NEt₂)₄ ; et M₂(NMe₂)₆ ; avec M = molybdène ou tungstène, Me = -CH₃, Et =-CH₂-CH₃.

De manière encore plus avantageuse, le précurseur du métal M est Mo(NMe₂)₄, Mo(NEtMe)₄ ; Mo(=N-CMe₃)₂(NMe₂)₂ ; ou W(=N-CMe₃)₂(NMe₂)₂. Dans ce cas, la température de mise en oeuvre du procédé est température est avantageusement comprise entre 20 et 350°C.

En ce qui concerne le précurseur de l'élément Y, il est avantageusement dépourvu d'halogènes et d'oxygène.

Typiquement, le précurseur de l'élément Y peut être choisi dans le groupe comprenant YR₂ ; Y₂R ; Y₂R₂ ; Y₃R₂ ; Y₂R₃ (avec R = H et/ou alkyle et/ou allyle et/ou aryle ; et R = C dans le cas de Y₂R).

Le groupement alkyle R mentionné ci-dessus est avantageusement un alkyle linéaire ou ramifié comprenant 1 à 8 atomes de carbone, et encore plus avantageusement 1 à 4 atomes de carbone.

Le précurseur de l'élément Y peut être utilisé seul ou en mélange avec l'hydrogène. Les composés Y₂R₂ et Y₃R₂ sont avantageusement utilisés en mélange avec l'hydrogène. Cet hydrogène peut avantageusement être sous forme de plasma.

Le précurseur de l'élément Y peut notamment être choisi dans le groupe comprenant le disulfure de méthyle ; le disulfure d'éthyle ; le diséléniure de méthyle ; le diséléniure d'éthyle ; et le 1,2-ethanedithiol (Y₂R₃ = HS-C₂H₄-SH).

Selon un mode de réalisation préféré, le précurseur de l'élément Y peut être :
- H₂Y seul ; ou
- 1,2-ethanedithiol (HS-CH₂CH₂-SH) seul ; ou
- le mélange H₂/Y₂R₂.

Selon un mode de réalisation particulier, la mise en oeuvre (introduction dans l'enceinte de dépôt par ALD) du précurseur de l'élément Y (seul ou en mélange avec l'hydrogène) peut être assistée par plasma. La présence d'un plasma peut ainsi permettre d'abaisser la température de dépôt. De manière générale, ce mode de réalisation particulier ne concerne pas le précurseur du métal M.

Selon un mode de réalisation préféré, le précurseur de l'élément Y est H₂Y, seul ou en mélange avec l'hydrogène.

L'introduction du précurseur de l'élément Y dans la chambre de dépôt peut également être suivie d'un pulse d'hydrogène qui permet de nettoyer les traces éventuelles de ligand restant et réactiver la surface pour le prochain pulse du précurseur de M.

Comme indiqué ci-avant, un mélange de précurseurs peut également être utilisé. Par exemple, un mélange hydrogène/polysulfure d'alkyle tel que le disulfure de diméthyle DMDS ou le disulfure de diéthyle DEDS, peut être utilisé. Ce mélange produit in-situ un mélange de thiols et de H₂S à partir de 150°C et en présence de Mo ou W.

En outre, l'utilisation d'un mélange contenant un précurseur de l'élément Y et l'hydrogène peut présenter les avantages suivants :
- possibilité d'obtenir un mélange oxydant ou réducteur (pouvant comprendre plusieurs composés précurseurs de l'élément Y) en fonction de la température et de la teneur en hydrogène, permettant ainsi de mieux contrôler le ratio Y/M ;
- la présence d'hydrogène favorise la formation de groupements -YH à la surface du substrat. La présence de ces groupements est particulièrement avantageuse en raison de leur meilleure réactivité vis-à-vis du précurseur du métal M par rapport à des groupements -Y-alkyle ;
- alternativement, un plasma d'hydrogène peut être utilisé en tant que gaz vecteur d'un disulfure ou diséléniure d'alkyle, permettant ainsi d'abaisser la température de réaction par formation de radicaux Y• plus réactifs.

### Recuit

Le procédé - objet de l'invention, peut comprendre une étape optionnelle de recuit à l'issue de la formation de la couche mince de formule MYₓ. Elle permet de former une couche mince cristalline dont la formule est avantageusement MY₂. En effet, lors du recuit, l'éventuel excès de composé Y est éliminé. Par conséquent, à l'issue du recuit, x est avantageusement égal à 2.

Comme déjà indiqué, le dépôt par ALD permet de contrôler la formation de la couche mince qui peut être amorphe, partiellement cristalline ou totalement cristalline à l'issue du dépôt.

Cependant, et de manière avantageuse, la température de dépôt par ALD ne permet pas la cristallisation de la couche mince de MYₓ. Cette condition permet notamment d'éviter la formation de cristaux orientés de manière totalement aléatoire par rapport au substrat.

Ainsi, la nature des précurseurs mis en oeuvre permet d'opérer à une température inférieure à la température de cristallisation du matériau MYₓ. Ce n'est qu'à l'issue de sa formation que de la couche mince de MYₓ peut être cristallisée, lors d'une étape de recuit.

L'étape de recuit est donc particulièrement adaptée aux cas où la couche de MYₓ déposée est amorphe ou partiellement cristalline.

Lors du recuit, la couche mince est densifiée. Ainsi, et de manière avantageuse, la couche mince forme un réseau cristallin dont les plans basaux (feuillets) sont avantageusement empilés dans des plans parallèles à la surface du substrat sur lequel elle est formée.

Typiquement, la température de recuit est avantageusement comprise entre 200 et 1000°C, plus avantageusement entre 350 et 700 °C.

De manière avantageuse, la température du recuit peut être comprise entre 800 et 850°C sous argon, ou entre 450 et 500°C sous hydrogène.

De manière générale, le recuit est réalisé sous vide ou sous atmosphère inerte (azote, argon,...) afin d'éviter une réaction de l'oxygène de l'air avec le dépôt. Alternativement, il peut être réalisé sous hydrogène afin de faciliter la cristallisation, et l'élimination de l'excédent de Y si nécessaire.

Les avantages liés à l'étape de recuit peuvent être les suivants :
- faible rugosité de la surface, par rapport aux couches minces de l'art antérieur dont le dépôt à haute température favorise généralement une croissance en bordure des cristallites, ce qui conduit à des structures en pétales, microsphères ou microtubes.
- accès à différentes phases cristallines du MoS₂ selon la température et la durée du recuit.
- contrôle de l'orientation des plans cristallins en fonction des conditions de recuit et de la nature du substrat, avec par exemple la possibilité d'obtenir des feuillets cristallins dont les plans basaux sont orientés parallèlement au plan du substrat sur lequel est déposée la couche mince.

### Substrat

Comme déjà indiqué, l'ordre d'introduction des précurseurs de M ou Y peut dépendre de la nature du substrat.

Le dépôt est réalisé sur un substrat pouvant être chauffé, de manière à ce que sa température soit suffisante pour observer une croissance auto-limitée sans résidus ni décomposition thermique non contrôlée des précurseurs.

La surface du substrat sur laquelle le dépôt de la couche mince est réalisé, est avantageusement en un matériau choisi dans le groupe comprenant un métal ; un semi-conducteur ; un polymère ; un substrat organique ; un oxyde inorganique ; un oxyde d'un métal ; un sulfure d'un métal ; un séléniure d'un métal ; un sulfure inorganique ; et un séléniure inorganique.

Les substrats semi-conducteurs peuvent notamment être en silicium ou en germanium.

De manière générale, les surfaces possédant des terminaisons en -OH, -SH, -SeH sont particulièrement adaptées aux pulses de précurseur d'un métal c'est-à-dire l'introduction initiale de précurseur du métal M alors que des surfaces métalliques sont généralement plus adaptées à l'introduction initiale du précurseur de l'élément Y.

Selon un mode de réalisation particulier, avant la mise en oeuvre du procédé objet de l'invention, le substrat peut être soumis à un traitement chimique visant à former ou à introduire les terminaisons en -OH, -SH ou -SeH précédemment évoquées. L'hydratation contrôlée d'un support type oxyde de métal permettra par exemple de rendre la surface réactive en formant des groupements -OH. En outre, le greffage de composés type chloro- ou alkoxy-silanes possédant une fonctionnalité réactive vis-à-vis du précurseur du métal M pourra être mis en oeuvre avant le dépôt de la couche mince MYₓ.

### Couche mince et son utilisation

La présente invention concerne également la couche mince MYx susceptible d'être obtenue par le procédé décrit ci-avant, mais aussi son utilisation, notamment dans l'électronique.

Les domaines d'utilisation de la couche mince incluent notamment le domaine du photovoltaïque et la production d'hydrogène par électrolyse de l'eau (HER, de l'acronyme anglais « *hydrogen evolution reaction* »)*.*

La couche mince de MYₓ peut comprendre une couche superficielle partiellement ou totalement oxydée, notamment par exposition à l'air. Dans ce cas, elle peut être considérée comme une couche de protection du matériau couche mince de MYₓ.

D'autre part, une couche superficielle (de type graphite ou oxyde de métal ou nitrure de métal) peut être délibérément mise en place à la fin du procédé de manière à passiver la couche MYₓ. Cette étape optionnelle peut être réalisée avant ou après le recuit.

L'invention et les avantages qui en découlent ressortiront mieux des figures et exemples suivants donnés afin d'illustrer l'invention et non de manière limitative.

### DESCRIPTION DES FIGURES

La figure 1 illustre le spectre XPS général d'un échantillon de MoS_{1.8} obtenu selon le procédé objet de l'invention.
La figure 2 illustre le spectre XPS haute résolution (raies Mo_{3d}) d'un échantillon de MoS_{1.8} obtenu selon le procédé objet de l'invention.
La figure 3 illustre le spectre XPS haute résolution (raies S₂ₚ) d'un échantillon de MoS_{1.8} obtenu selon le procédé objet de l'invention.

### EXEMPLES DE REALISATION DE L'INVENTION

Dépôt d'une couche mince de MoS_{1.8} (M = Mo ; Y = S ; x = 1.8) à partir du tetrakis(dimethylamino)molybdène (IV) et du 1,2 ethanedithiol selon le procédé objet de l'invention

Le dépôt est réalisé sur un substrat de 275 nm d'épaisseur en SiO₂ dans un réacteur ALD, en alternant des pulses de tetrakis(dimethylamino)molybdène (IV) Mo(NMe₂)₄ et de 1,2-ethanedithiol, précédés d'un cycle de purge (60 sccm d'argon à une pression de 10 torr, soit 1333 Pa, pendant 2 minutes). (1 sccm = 1 cm³ standard/minute).

Le substrat (et l'échantillon en formation) est maintenu à la température de 100°C pendant toute la durée du dépôt.

Le tetrakis(dimethylamino)molybdène (IV) est saturé à 20°C/10 torr dans un flux d'argon de 40 sccm.
La durée du pulse pour le précurseur métallique est de 5 minutes.

Le 1,2-ethanedithiol (≥98% de chez Sigma-Aldrich) est saturé à 20°C/760 torr dans un flux d'argon de 60 cm³/minute.
La durée du pulse pour le précurseur soufré est de 5 minutes.

Au total, cinq cycles «précurseur métallique - purge - précurseur soufré - purge » sont réalisés.
L'échantillon est ensuite recuit 10 min à 800°C sous flux continu d'argon (10 torr, 100 sccm).

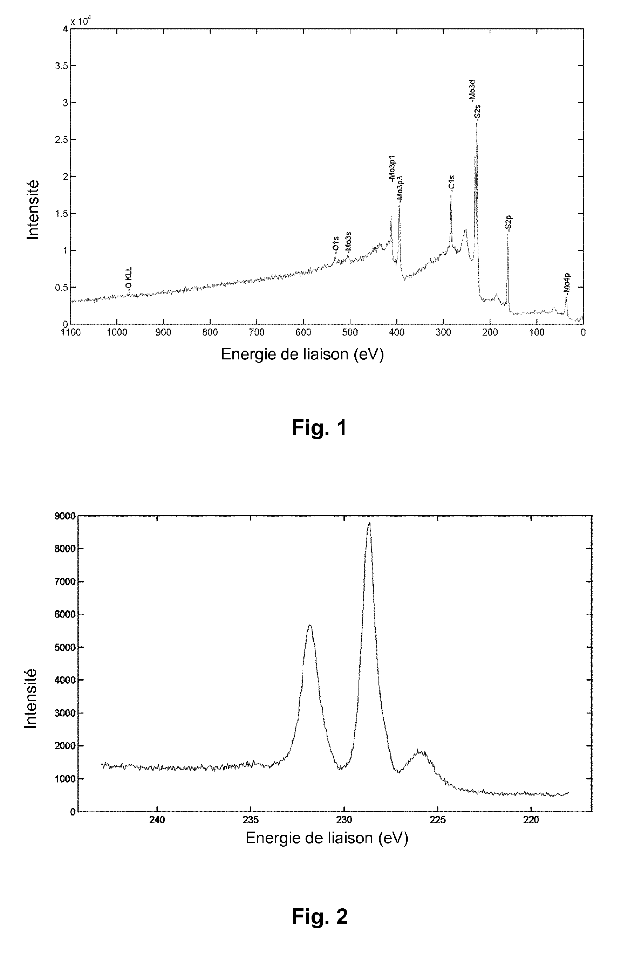

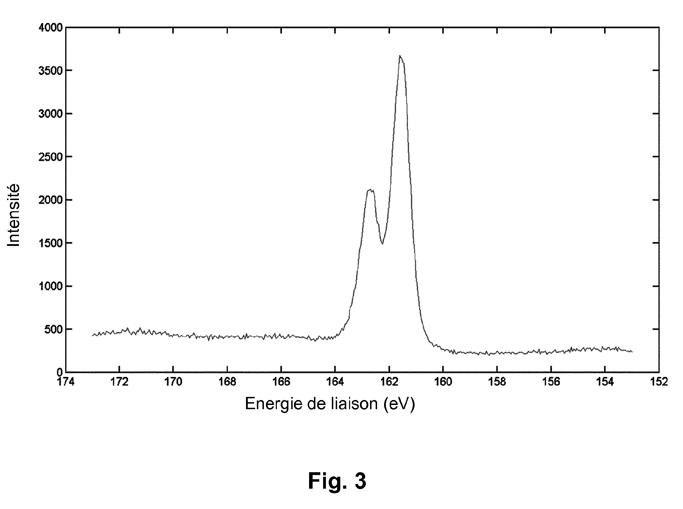

Les analyses par XPS (spectrométrie de photoélectrons induits par rayons-X) révèlent une phase très proche de la stoechiométrie MoS₂ avec un ratio S/Mo = 1,8 (évalué à partir des raies Mo_{3d} à et S₂ₚ, figures 1 à 3).

## Revendications

1. Procédé de préparation par ALD d'une couche mince de formule MYₓ, x étant compris entre 1.5 et 3.1, selon lequel on réalise un dépôt de MYₓ par ALD sur un substrat, à partir d'au moins un précurseur du métal M, et d'au moins un précurseur de l'élément Y ;
- M étant le tungstène et/ou le molybdène ;
- le degré d'oxydation du métal M dans le précurseur du métal M étant compris entre 3 et 6 ;
- le métal du précurseur du métal M comprenant uniquement des liaisons simples ou multiples M-Z et/ou M-M avec Z = C, N, H, et toute combinaison de ces atomes ;
- Y étant le soufre et/ou le sélénium ;
- la température du substrat étant inférieure ou égale à 350 °C.

2. Procédé selon la revendication 1, ***caractérisé* en ce que** le dépôt par ALD comprend l'introduction dans une chambre de dépôt d'au moins un précurseur du métal M, et ensuite l'introduction d'au moins un précurseur de l'élément Y.

3. Procédé selon la revendication 1, ***caractérisé* en ce que** le dépôt par ALD comprend l'introduction dans une chambre de dépôt d'au moins un précurseur de l'élément Y, et ensuite l'introduction d'au moins un précurseur du métal M.

4. Procédé selon l'une des revendications 1 à 3, ***caractérisé* en ce que** le dépôt par ALD comprend d'une part l'introduction de précurseurs des métaux tungstène et/ou molybdène, et d'autre part l'introduction de précurseurs des éléments soufre et/ou sélénium.

5. Procédé selon l'une des revendications 1 à 4, ***caractérisé* en ce qu'**il comprend les étapes suivantes :
a) introduire un premier précurseur du métal M ou de l'élément Y dans une chambre de dépôt ;
b) purger la chambre de dépôt avec un gaz inerte ;
c) introduire un deuxième précurseur dans la chambre de dépôt, le deuxième précurseur étant un précurseur du métal M lorsque le premier précurseur est un précurseur de l'élément Y ou un précurseur de l'élément Y lorsque le premier précurseur est un précurseur du métal M ;
d) purger la chambre de dépôt avec un gaz inerte ;
e) réitération des étapes a) à d).

6. Procédé selon l'une des revendications 1 à 5, ***caractérisé* en ce que** la température du substrat est comprise entre 0 et 350 °C, et avantageusement entre 120 et 300 °C.

7. Procédé selon l'une des revendications 1 à 6, ***caractérisé* en ce que** le précurseur du métal M est choisi dans le groupe comprenant Mo(NMe₂)₄ ; M(=N-CMe₃)₂(NMe₂)₂; Mo(NEtMe)₄ ; Mo(NEt₂)₄; et M₂(NMe₂)₆; avec M = molybdène ou tungstène, Me = -CH₃, Et = -CH₂-CH₃.

8. Procédé selon l'une des revendications 1 à 7, ***caractérisé* en ce que** le précurseur de l'élément Y est choisi dans le groupe comprenant YR₂ ; Y₂R ; Y₂R₂ ; Y₃R₂ ; et Y₂R₃, avec R = H et/ou alkyle et/ou allyle et/ou aryle, et R = C pour Y₂R.

9. Procédé selon l'une des revendications 1 à 8, ***caractérisé* en ce que** les précurseurs du métal M et de l'élément Y sont dépourvus d'halogènes et d'oxygène.

10. Procédé selon l'une des revendications 1 à 9, ***caractérisé* en ce qu'**il comprend une étape de recuit après la formation de la couche mince de formule MYₓ, la température de recuit étant comprise entre 200 et 1000°C.

11. Procédé selon l'une des revendications 1 à 10, ***caractérisé* en ce que** la température du substrat est comprise entre 20 et 350°C, avantageusement entre 20 et 300°C.

12. Procédé selon l'une des revendications 1 à 11, ***caractérisé* en ce que** le précurseur du métal M est Mo(NMe₂)₄ ; Mo(NEtMe)₄ ; Mo(=N-CMe₃)₂(NMe₂)₂ ; ou W(=N-CMe₃)₂(NMe₂)₂.

13. Procédé selon l'une des revendications 1 à 12, ***caractérisé* en ce que** le précurseur de l'élément Y est choisi dans le groupe comprenant H₂Y ; 1,2-ethanedithiol ; et le mélange H₂/Y₂R₂, avec R = H et/ou alkyle et/ou allyle et/ou aryle.

14. Procédé selon l'une des revendications 1 à 13, ***caractérisé* en ce que** la mise en oeuvre du précurseur de l'élément Y est assistée par plasma.

15. Procédé selon l'une des revendications 1 à 14, ***caractérisé* en ce que** la surface du substrat sur laquelle le dépôt de la couche mince est réalisé, est en un matériau choisi dans le groupe comprenant un métal ; un semi-conducteur ; un polymère ; un substrat organique ; un oxyde inorganique ; un oxyde d'un métal ; un sulfure d'un métal ; un séléniure d'un métal ; un sulfure inorganique ; et un séléniure inorganique.

## Patentansprüche

1. Verfahren zur Herstellung durch ALD einer dünnen Schicht der Formel MYₓ, wobei x zwischen 1.5 und 3.1 liegt, dabei wird eine Schicht MYₓ durch ALD auf einem Substrat abgelagert, ausgehend von mindestens einem Precursor des Metalls M und mindestens einem Precursor des Metalls Y;
- M kann Wolfram und/oder Molybdän sein;
- der Oxidationsgrad des Metalls M im Precursor des Metalls M liegt zwischen 3 und 6;
- das Metall des Precursors des Metalls M enthält ausschließlich einfache oder vielfache M-Z- und/ oder M-M- Bindungen mit Z = C, N, H und alle Kombinationen dieser Atome;
- Y ist Schwefel und/oder Selenium;
- die Temperatur des Substrats ist kleiner oder gleich 350°C.

2. Verfahren gemäß Anspruch 1, ***dadurch gekennzeichnet, dass*** die Ablagerung durch ALD umfasst, in eine Beschichtungskammer mindestens einen Precursor des Metalls M einzuführen, und dann mindestens einen Precursor des Elements Y.

3. Verfahren gemäß Anspruch 1, ***dadurch gekennzeichnet, dass*** die Ablagerung durch ALD umfasst, in eine Beschichtungskammer mindestens einen Precursor des Elements Y einzuführen, und danach mindestens einen Precursor des Metalls M.

4. Verfahren gemäß einem der Ansprüche 1 bis 3, ***dadurch gekennzeichnet, dass*** die Ablagerung durch ALD einerseits die Einführung von Vorläufern der Metalle Wolfram und/ oder Molybdän und andererseits die Einführung der Elemente Schwefel und/ oder Selenium umfasst.

5. Verfahren gemäß einem der Ansprüche 1 bis 4, **dadurch gekennzeichnet, dass** es die folgenden Etappen umfasst:
a) Einfühning eines ersten Precursors des Metalls M oder des Elements Y in eine Beschichtungskammer;
b) Reinigung der Beschichtungskammer mit einem inerten Gas;
c) Einfühning eines zweiten Precursors in die Beschichtungskammer, wobei der zweite Precursor ein Precursor des Metalls M ist, wenn der erste Precursor ein Precursor des Elements Y ist oder ein Precursor des Elements Y, wenn der erste Precursor ein Precursor des Metalls M ist;
d) Reinigung der Beschichtungskammer mit einem inerten Gas;
e) Wiederholung der Etappen a) bis d).

6. Verfahren gemäß einem der Ansprüche 1 bis 5, ***dadurch gekennzeichnet, dass*** die Temperatur des Substrats zwischen 0 und 350°C liegt und am besten zwischen 120 und 300°C.

7. Verfahren gemäß einem der Ansprüche 1 bis 6, ***dadurch gekennzeichnet, dass*** der Precursor des Metalls aus der Gruppe ausgewählt wird, die umfasst Mo(NMe₂)₄; M(=N- CMe₃)₂(NMe₂)₂; Mo(NEtMe)₄; Mo(NEt₂)₄; und M₂(NMe₂)₆; mit M = Molybdän oder Wolfram, Me = -CH₃, Et = -CH₂-CH₃.

8. Verfahren gemäß einem der Ansprüche 1 bis 7, ***dadurch gekennzeichnet, dass*** der Precursor des Elements Y aus der Gruppe ausgewählt wird, die umfasst YR₂; Y₂R; Y₂R₂; Y₃R₂; und Y₂R₃, mit R = H und/oder/Alkyl und/oder/Allyl und/oder/Aryl und R = C für Y₂R.

9. Verfahren gemäß einem der Ansprüche 1 bis 8, ***dadurch gekennzeichnet*, *dass*** die Precursoren des Metalls M und des Elements Y keine Halogene und keinen Sauerstoff enthalten.

10. Verfahren gemäß einem der Ansprüche 1 bis 9, ***dadurch gekennzeichnet*, *dass*** es eine Glühphase nach Bildung der dünnen Schicht der Formel Myₓ umfasst, die Glühtemperatur liegt dabei zwischen 200 und 1000°C.

11. Verfahren gemäß einem der Ansprüche 1 bis 10, ***dadurch gekennzeichnet, dass*** die Substrattemperatur zwischen 20 und 350°C liegt, besser noch zwischen 20 und 300°C.

12. Verfahren gemäß einem der Ansprüche 1 bis 11, ***dadurch gekennzeichnet*, *dass*** der Precursor des Metalls M Mo(NMe₂)₄; Mo(NEtMe)₄; Mo (=N-CMe₃)₂(NMe₂)₂; oder W(=N-CMe₃)₂(NMe₂)₂ ist.

13. Verfahren gemäß einem der Ansprüche 1 bis 12, ***dadurch gekennzeichnet, dass*** der Precursor des Elements Y aus der Gruppe ausgewählt wird, die umfasst H₂Y; 1,2-ethanedithiol; sowie die Mischung H2/Y₂R₂, mit R = H und/oder Alkyl und/ oder Allyl und/ oder Aryl.

14. Verfahren gemäß einem der Ansprüche 1 bis 13, ***dadurch gekennzeichnet*, *dass*** der Einsatz des Precursors des Elements Y durch Plasma unterstützt wird.

15. Verfahren gemäß einem der Ansprüche 1 bis 14, ***dadurch gekennzeichnet*, *dass*** die Substratoberfläche, auf der die dünne Schicht abgelagert wird, aus einem Material besteht, das ausgewählt wird aus der Gruppe, die ein Metall, einen Halbleitern; ein Polymer; ein organisches Substrat; ein anorganisches Oxid; ein Metalloxid; ein Metallsulfid, ein Metallselenid; ein anorganisches Sulfid; und einem anorganischen Selenid.

## Claims

1. A method of preparing by ALD a thin film of formula MYₓ, x being in the range from 1.5 to 3.1, according to which a deposition of MYₓ by ALD is performed on a substrate, from at least one precursor of metal M and at least one precursor of element Y;
- M being tungsten and/or molybdenum;
- the degree of oxidation of metal M in the precursor of metal M being in the range from 3 to 6;
- the metal of the precursor of metal M only comprising simple or multiple bonds M-Z and/or M-M with Z = C, N, H, and any combination of these atoms;
- Y being sulfur and/or selenium;
- the substrate temperature being lower than or equal to 350°C.

2. The method of claim 1, ***characterized* in that** the ALD deposition comprises introducing into a deposition chamber at least one precursor of metal M, and then introducing at least one precursor of element Y.

3. The method of claim 1, ***characterized* in that** the ALD deposition comprises introducing into a deposition chamber at least one precursor of element Y, and then introducing at least one precursor of metal M.

4. The method of any of claims 1 to 3, ***characterized* in that** the ALD deposition comprises, on the one hand, introducing precursors of metals tungsten and/or molybdenum and, on the other hand, introducing precursors of elements sulphur and/or selenium.

5. The method of any of claims 1 to 4, ***characterized* in that** it comprises the steps of:
a) introducing a first precursor of metal M or of element Y into a deposition chamber;
b) purging the deposition chamber with an inert gas;
c) introducing a second precursor into the deposition chamber, the second precursor being a precursor of metal M when the first precursor is a precursor of element Y or a precursor of element Y when the first precursor is a precursor of metal M;
d) purging the deposition chamber with an inert gas;
e) repeating steps a) to d).

6. The method of any of claims 1 to 5, ***characterized in that*** the substrate temperature is in the range from 0 to 350°C, and advantageously from 120 to 300°C.

7. The method of any of claims 1 to 6, ***characterized in that*** the precursor of metal M is selected from the group comprising Mo(NMe₂)₄; M(=N-CMe₃)₂(NMe₂)₂; Mo(NEtMe)₄; Mo(NEt₂)₄; and M₂(NMe₂)₆; with M = molybdenum or tungsten, Me = -CH₃, Et = -CH₂-CH₃.

8. The method of any of claims 1 to 7, ***characterized* in that** the precursor of element Y is selected from the group comprising YR₂; Y₂R; Y₂R₂; Y₃R₂; and Y₂R₃, with R = H and/or alkyl and/or allyl and/or aryl, and R = C for Y₂R.

9. The method of any of claims 1 to 8, ***characterized* in that** the precursors of metal M and of element Y are deprived of halogens and oxygen.

10. The method of any of claims 1 to 9, ***characterized* in that** it comprises an anneal step after the forming of the thin film of formula MYₓ, the anneal temperature being in the range from 200 to 1,000°C.

11. The method of any of claims 1 to 10, ***characterized* in that** the substrate temperature is in the range from 20 to 350°C, advantageously from 20 to 300°C.

12. The method of any of claims 1 to 11, ***characterized* in that** the precursor of metal M is Mo(NMe₂)₄; Mo(NEtMe)₄; Mo(=N-CMe₃)₂(NMe₂)₂; or W(=N-CMe₃)₂(NMe₂)₂.

13. The method of any of claims 1 to 12, ***characterized* in that** the precursor of element Y is selected from the group comprising H₂Y; 1,2-ethanedithiol; and the H₂/Y₂R₂ mixture, with R = H and/or alkyl and/or allyl and/or aryl.

14. The method of any of claims 1 to 13, ***characterized* in that** the use of the precursor of element Y is plasma-assisted.

15. The method of any of claims 1 to 14, ***characterized* in that** the surface of the substrate having the thin film deposited thereon is made of a material selected from the group comprising a metal; a semiconductor; a polymer; an organic substrate; an inorganic oxide; a metal oxide; a metal sulphide; a metal selenide; an inorganic sulphide; and an inorganic selenide.
